# EUROPEAN PATENT APPLICATION

(11) **EP 1 443 016 A2**
(43) Date of publication of application: **04.08.2004**
(21) Application number: 03020079.4
(22) Date of filing: 04.09.2003
(51) Int. Cl.: B81B 3/00, B81C 1/00

(54) **Micro-Fabricated device and method of making same**

(30) Priority: 29.01.2003 US 353332
(71) Applicant: Hewlett-Packard Development Company, L.P., Houston, TX 77070 (US)
(72) Inventor: McKinnell, James C., Salem OR 97304 (US); Liebeskind, John, Corvallis OR 97330 (US); Chen, Chien-Hua, Corvallis OR 97330 (US)
(74) Representative: Schoppe, Fritz, Dipl.-Ing.

(57) **Abstract**

A micro-fabricated device (100, 200, 300, 500, 600, 700), includes a support structure (140, 140', 240, 340, 440, 540, 640, 740) and a device substrate (130, 130', 230, 330, 430, 530, 630, 730) disposed a distance G from the support structure. The micro-fabricated device further includes one or more thermally isolating structures (120, 120', 220, 220', 320, 320',420a, 420b, 420c, 520, 620, 720) that have a characteristic length (118, 218, 318, 318', 418a, 418b, 418c, 518, 618), and the one or more thermally isolating structures is thermally coupled to the device substrate and the support structure. The characteristic length is greater than said distance G.

## Description

### BACKGROUND

### Description of the Art

Over the past decade, the demand for cheaper and higher performance electronic devices has led to a growing need to manufacture electronic devices having lower power consumption as well as improved thermal efficiency. Microprocessors are a good example of the ever-increasing demands on power consumption and the need to better handle thermal transfer. Today's high performance computing devices, if left unaltered will result in peak temperatures that will destroy or damage the silicon-based devices on which microprocessors are typically formed. In addition, users of mobile personal computers and personal digital assistants are demanding more and more functionality or performance with little or no noticeable effect on battery life.

Demand for improved thermal efficiency is also increasing in the emerging area of Micro Electro Mechanical Systems (MEMS), which are being developed as smaller alternative systems, to conventional electromechanical devices such as relays, actuators, sensors, valves, and other transducers. Such electromechanical devices incorporated in a MEMS device can be integrated with integrated circuits providing improved performance over conventional systems. Many types of transducers, incorporated into MEMS devices, such as, vacuum sensors, gas flow sensors, infrared detectors, and AC power converters operate, in the detection of, or utilization of, a temperature difference that is isolated from the rest of the integrated circuit (IC). This increased complexity further increases the demands on improving thermal transfer both by maximizing thermal transfer in some cases and minimizing thermal transfer in other cases.

Currently as the level of integration increases the resulting complex devices often require compromises to be made because one portion of the device may require heat to be dissipated as quickly as possible and another portion of the device may require heat or cold to be confined as efficiently as possible. One solution to this problem that has been utilized is to separate the two devices so that the separate devices may each be optimized, however, such a solution results in the loss of the key benefits, of smaller size and improved performance, obtained by integration. In highly integrated systems, such as MEMS devices, different portions of the same device may operate more efficiently at temperatures significantly above or below ambient conditions. For example, a vacuum sensor may operate at its maximum efficiency at over a 100° C while associated CMOS circuitry processing the output of the vacuum sensor or controlling some other function may efficiently operate at room temperature or even sub-ambient temperatures such as -25° C. Generally, a solution to such a problem results in tradeoffs such as by, increasing the power applied to the vacuum sensor to heat it, while also increasing the cooling power applied to the CMOS circuitry to maintain it at a lower temperature, typically room temperature or below. The end result is an electronic device whose performance is compromised The inability to control thermal transfer can both, result in a significant increase in power consumption as well as less than optimum performance.

If these problems persist, the continued growth and advancements in the use electronic devices, especially MEMS devices, in various electronic products, seen over the past several decades, will be reduced. In areas like consumer electronics, the demand for cheaper, smaller, more reliable, higher performance electronics constantly puts pressure on improving and optimizing performance of ever more complex and integrated devices. The ability, to optimize thermal performance will open up a wide variety of applications that are currently either impractical, or are not cost effective.

### BRIEF DESCRIPTION OF THE DRAWINGS

Fig. 1a is a top view of a micro-fabricated device according to an embodiment of the present invention;

Fig. 1b is a cross-sectional view of the micro-fabricated device shown in Fig. 1a according to an embodiment of the present invention;

Fig. 1c is a cross-sectional view of the micro-fabricated device shown in Fig. 1a according to an alternate embodiment of the present invention;

Fig. 1d is a cross-sectional view of the micro-fabricated device shown in Fig. 1a according to an alternate embodiment of the present invention;

Fig. 1e is a cross-sectional view of the micro-fabricated device shown in Fig. 1a according to an alternate embodiment of the present invention;

Fig. 2a is a top view of a micro-fabricated device according to an alternate embodiment of the present invention;

Fig. 2b is a cross-sectional view of the micro-fabricated device shown in Fig. 2a according to an embodiment of the present invention;

Fig. 3a is a top view of a micro-fabricated device according to an alternate embodiment of the present invention;

Fig. 3b is a cross-sectional view of the micro-fabricated device shown in Fig: 3a according to an embodiment of the present invention;

Fig. 3c is a cross-sectional view of the micro-fabricated device shown in Fig. 3a according to an alternate embodiment of the present invention;

Fig. 4a is a top view of a thermally isolating structure according to an alternate embodiment of the present invention;

Fig. 4b is a top view of a thermally isolating structure according to an alternate embodiment of the present invention;

Fig. 4c is a top view of a thermally isolating structure according to an alternate embodiment of the present invention;

Fig. 5a is a top view of a micro-fabricated device according to an alternate embodiment of the present invention;

Fig. 5b is a cross-sectional view of the micro-fabricated device shown in Fig. 5a;

Fig. 6a is a top view of a micro-fabricated device according to an alternate embodiment of the present invention;

Fig. 6b is a cross-sectional view of the micro-fabricated device shown in Fig. 6a;

Fig. 7 is a cross-sectional view of a micro-fabricated device having an integrated vacuum device according to an alternate embodiment of the present invention;

Fig. 8 is a block diagram of an electronic device according to an embodiment of the present invention;

Fig. 9 is a flow chart of a method of making a micro-fabricated device according to an embodiment of the present invention;

Fig. 10a-10h are cross-sectional views of various processes used to create embodiments of the present invention.

### DESCRIPTION OF THE PREFERRED EMBODIMENTS

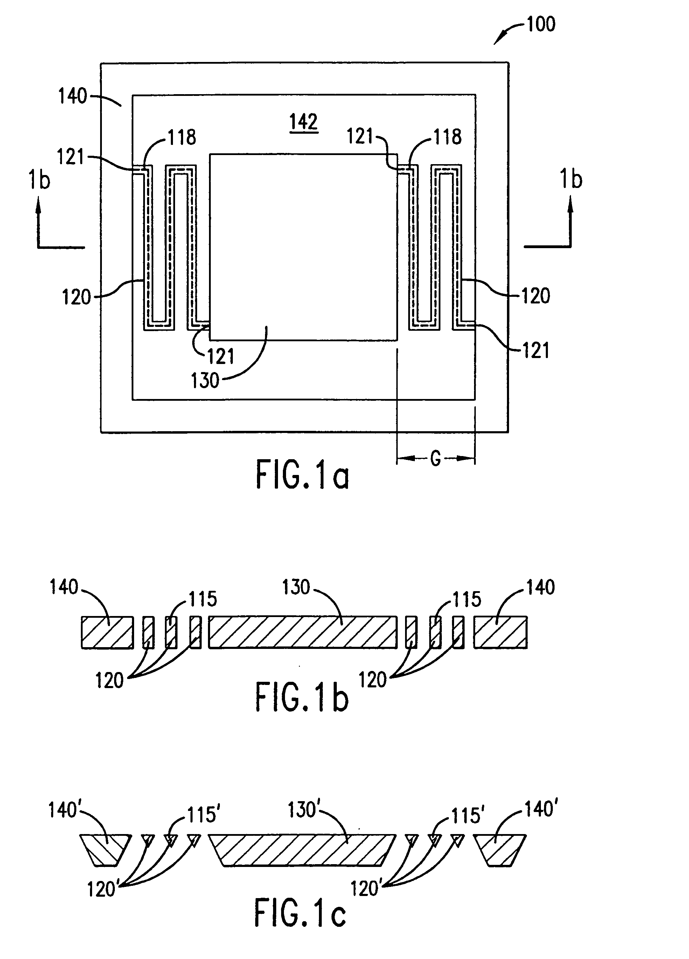

Referring to Fig. 1a, an embodiment of micro-fabricated device 100 of the present invention is shown in a top view. In this embodiment, thermally isolating structure 120 reduces the thermal conduction between device substrate 130 and support structure 140 while providing mechanical support. Device substrate 130 is disposed, within aperture 142 formed in support structure 140, distance G from support structure 140 and thermally isolating structure 120 is thermally coupled to device substrate 130 and support structure 140 at attachment points 121. In addition, thermally isolating structure 120 has characteristic length or thermal conduction path 118, measured between attachment points 121 that is greater than distance G. In this embodiment, thermal conduction path 118 is at least twice as long as distance G; however, in alternate embodiments, path 118 may be shorter or longer depending on the particular application in which micro-fabricated device 100 is utilized. By utilizing a serpentine path or folded structure, such as thermal conduction path 118, device substrate 130 may be heated or cooled to a temperature different from the temperature of support structure 140 more efficiently than a straight or shorter conduction path having the same cross-sectional area. Whether device substrate 130 is heated or cooled will depend, for example, on the particular application in which micro-fabricated device 100 will be utilized.

It should be noted that the drawings are not true to scale. Further, various elements have not been drawn to scale. Certain dimensions have been exaggerated in relation to other dimensions in order to provide a clearer illustration and understanding of the present invention.

In addition, although some of the embodiments illustrated herein are shown in two dimensional views with various regions having depth and width, it should be clearly understood that these regions are illustrations of only a portion of a device that is actually a three dimensional structure. Accordingly, these regions will have three dimensions, including length, width, and depth, when fabricated on an actual device. Moreover, while the present invention is illustrated by various embodiments, it is not intended that these illustrations be a limitation on the scope or applicability of the present invention. Further it is not intended that the embodiments of the present invention be limited to the physical structures illustrated. These structures are included to demonstrate the utility and application of the present invention.

Device substrate 130, thermally isolating structure 120, and support structure 142 form a substantially planar structure as shown, in a cross-sectional view, in Fig. 1b. In this embodiment, micro-fabricated device 100 is formed from the same material. For example, a silicon wafer may be utilized to form device substrate 130, thermally isolating structure 120, and support structure 140. In alternate embodiments micro-fabricated device 100 may be formed utilizing wafers or substrates made from materials such as glass, ceramic, silicon, gallium arsenide, germanium, indium phosphide, metals, and various polymers to name a few. The particular material utilized for micro-fabricated device 100 will depend on various parameters such as the particular application in which the device will be utilized, both process and operating temperatures, presence or absence of active electronic devices, and the thermal and mechanical properties of the device. In addition, cross-sectional area 115 of thermally isolating structure 120 may be varied to further tune the thermal conduction of isolating structure 120 by varying the thickness of thermally isolating structure 120. For example, if micro-fabricated device 100 is formed on a silicon wafer cross-sectional area 115 may have the same thickness as that of device substrate 130 and support structure 140 by utilizing an isotropic etch, as shown in Fig. 1b; whereas an anisotropic etch may be utilized to provide a reduced thickness, and corresponding smaller cross-sectional area 115' leading to lower thermal conduction for thermally isolating structure 120' shown, in a cross-section view, in Fig. 1c.

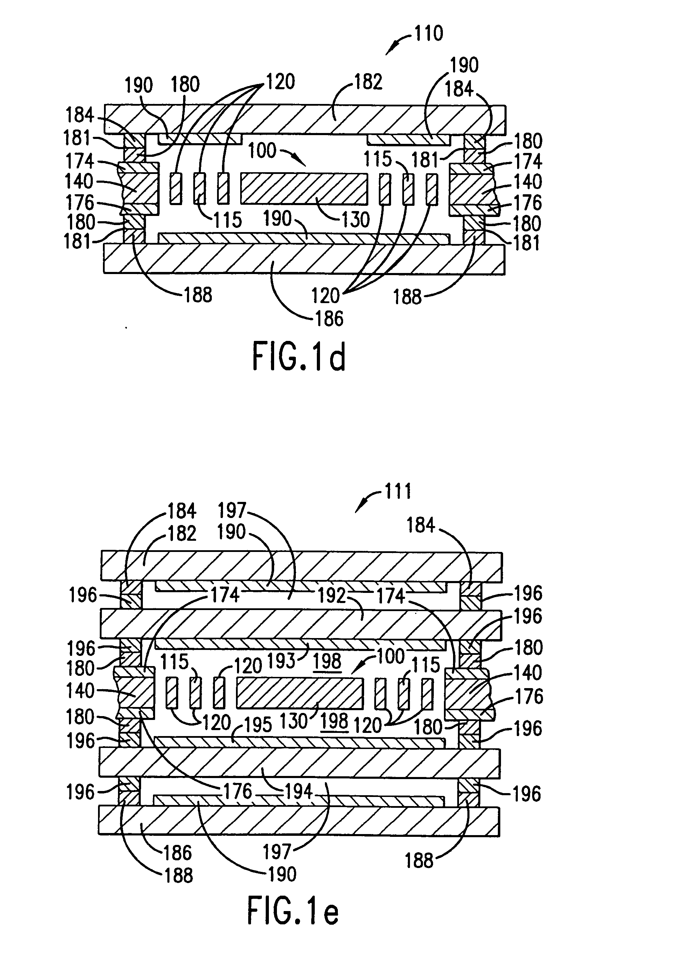

Referring to Fig. 1d, an alternate embodiment of micro-fabricated device 100 of the present invention is shown in a cross-sectional view. In this embodiment, micro-fabricated device 100 is enclosed in sealed package 110. Sealed package 110 is a vacuum package providing additional thermal control, by reducing thermal transfer by convection, between device substrate 130 and the ambient environment. However, in alternate embodiments, sealed package 110 may also be an enclosure providing fluid flow for other applications such as, for example, micro turbines, fuel cells, chemical reactors, and catalytic fuel crackers.

Device bond structure 180 is formed on support structure 140 over dielectric passivation layer 174 and second dielectric layer 176, which provide electrical isolation. Cover or lid bond structures 184 are formed on cover or lid 182, and base or package bottom bond structures 188 are formed on base or package bottom 186. In this embodiment, device bond structure 180 may utilize a gold-silicon eutectic for bonding the silicon die to a ceramic package or metal can, or it may also utilize a softer lower melting-point solder, these are just a couple of examples of the various materials that may be utilized. In alternate embodiments, a frit glass seal may be utilized to attach micro-fabricated device 100 to cover 184 and base 186. The material utilized for bond structures 180, 184 and 188 will depend on the particular materials utilized for support structure 140, lid 182, and base 186. Lid 182 and base 186 may utilize various, ceramic, glass, or metal materials or combinations of these materials. The particular material will depend on, for example, the desired pressure to be maintained; the temperature and humidity and other environmental factors to which the micro-fabricated device will be exposed; and the amount of stress that may be imparted to the micro-fabricated device as a result of the packaging process; as well as, the particular sealing technology to be utilized. These same parameters are also considered when determining the material to be utilized as bond structures. In this embodiment, seal 181 can be made by a variety of techniques such as, for example, thermal compression bonding or brazing, as well as other techniques.

A low melting-point inorganic oxide such as, for example, lead oxide or boric oxide may also be used for bond structures 180, 184, and 188 to generate seal 181. In still other embodiments, anodic bonding may be utilized to attach micro-fabricated device 100 made out of silicon to a cover and base each either made out of glass or having a glass surface to bond to the silicon. The silicon surface of the micro-fabricated device and the glass surface of either the cover or base are placed between two electrodes so that an appropriate polarity voltage is applied across the interface of the two materials. After bonding of the first pair is completed the remaining base or cover is then bonded in the same manner. The particular bonding process will depend on various parameters such as the magnitude and duration of the applied voltage, the temperature of the two surfaces during the bonding surface, and the area to be bonded. Non-evaporable getter material 190 may also be applied or deposited on various portions of cover 182 and base 186 to provide pumping of residual gases within sealed package 110 during operation of micro-fabricated device 100.

Referring to Fig. 1e, an alternate embodiment of micro-fabricated device 100 of the present invention is shown in a cross-sectional view. In this embodiment, micro-fabricated device 100 is enclosed in package 111, that includes reflector layers 193 and 195 that are interposed between device substrate 130 and cover 182 and base 186 respectively. In this embodiment, package 111 includes a vacuum portion, providing additional thermal control by reducing thermal convection between device substrate 130 and the ambient environment, as well as, a radiation portion, providing further thermal control by reducing thermal losses due to radiation either to or from device substrate 130.

Device bond structure 180 is formed on support structure 140 over dielectric passivation layer 174 and second dielectric layer 176, which provide electrical isolation. Reflector bond structures 196 are formed on first reflector substrate 192 and second reflector substrate 194. In addition, cover or lid bond structures 184 are formed on cover or lid 182, and base bond structures 188 are formed on base or package bottom 186. Similar materials and processes as described above for the embodiment shown in Fig. 1d may also be utilized, in this embodiment, to form package 111. First reflector layer 193 and second reflector layer 195 are deposited on first reflector substrate 192 and second reflector substrate 194 respectively. In this embodiment, first reflector layer 193 and second reflector layer 195 may be formed from a metal such as gold, aluminum, tungsten, silver, and platinum to name just a few. In alternate embodiments, any material having the appropriate reflectivity in the wavelength region desired may also be utilized. The particular material utilized will depend on various parameters such as temperature of operation, presence or absence of oxygen, or other corrosive material, and the particular application in which micro-fabricated device 100 will be utilized. In this embodiment, first reflector layer 193 and second reflector layer 195 reflect thermal radiation emitted from device substrate 130.

Reflector substrate interspace region 197 between the cover and top reflector is maintained at a pressure below atmospheric pressure in this embodiment. Device interspace region 198 may be maintained at a pressure below atmospheric pressure for those applications utilizing a vacuum such as a vacuum sensor. However, in other embodiments, device interspace region 198 may be maintained at atmospheric or pressures above atmospheric pressures such as for catalytic reactors, or fuel cells. In still other embodiments device interspace region 198 may also be an enclosure providing fluid flow of either a gas or liquid depending on the application such as, for example, micro turbines, fuel cells, heat engines, chemical reactors, and catalytic fuel crackers. Non-evaporable getter material 190 may also be applied or deposited on various portions of cover 182 and base 186 to provide pumping of residual gases within reflector substrate interspace region 197 during operation of micro-fabricated device 100.

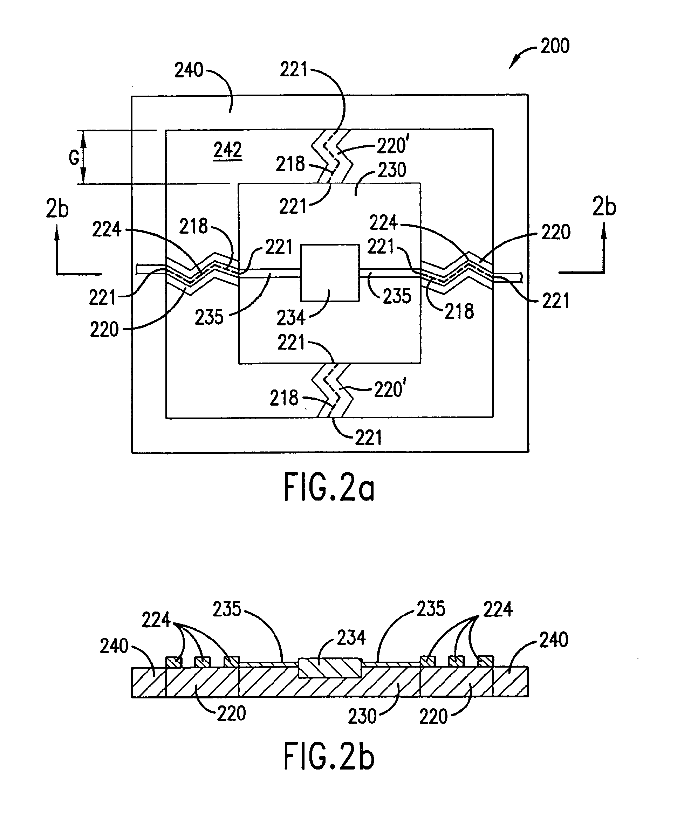

Referring to Fig. 2a, an alternate embodiment of micro-fabricated device 200 of the present invention is shown in a top view. In this embodiment, active device 234 and substrate electrical trace 235 are disposed on device substrate 230. Active device 234 is represented in Fig. 2a and 2b as only a single layer to simplify the drawing: Active device 234 includes for example transistors (including thin-film-transistor (TFT) or amorphous silicon transistors), diodes, logic cells, as well as sensors, transducers, electron emitters, bolometers, and superconductoring high Q RF filters to name just a few of the many active devices that may be utilized, either separately or in combination, in the present invention. In alternate embodiments, active device 234 may also be integrated with various MEMS devices such as microfluidic channels, reactor chambers, micromovers, and actuators to name just a few of the many MEMS devices that may be utilized. For example, micro-fabricated device 200 may include a micro mirror disposed on said device substrate 230 including a reflective surface disposed on said mirror. Another example is a bolometer or other radiation detector having a light absorbing surface disposed on said device substrate 230

Device substrate 230 is disposed, within aperture 242 formed in support structure 240, a distance G from support structure 240. Thermally isolating structure 220 attaches to device substrate 230 and support structure 240 at attachment points 221 as shown in Fig. 2a. In addition, thermally isolating structure 220 has characteristic length or thermal conduction path 218 measured between attachment points 221, that is greater than the gap between device substrate 230 and support structure 240 labeled as distance G. In this embodiment, thermally isolating structure 220 forms an accordion or chevron like structure to reduce the thermal conduction between device substrate 230 and support structure 240, as well as, providing mechanical support for device substrate 230. Thermally isolating structure 220 is formed to minimize tension in thermally isolating structure 220 and reduce stress applied to device substrate 230. Electrical interconnection trace 224, as shown in Figs. 2a-2b, is formed on thermally isolating structure 220 and electrically couples to substrate electrical trace 235. Whether device substrate 230 is heated or cooled depends, for example, on the particular application in which micro-fabricated device 200 will be utilized.

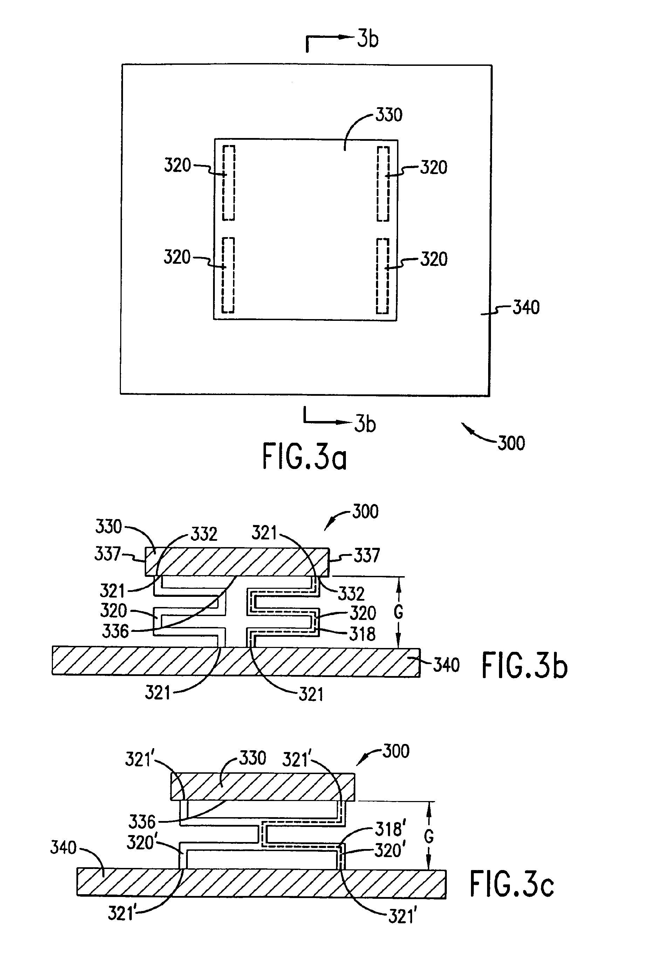

Referring to Fig. 3a, an alternate embodiment of micro-fabricated device 300, of the present invention, is shown in a top view. In this embodiment, device substrate 330 is disposed over support structure 340 forming a vertical structure. As can be seen, in a cross-sectional, view shown in Fig. 3b substrate 330 is separated a distance G from support structure 340. In this embodiment, thermally isolating structure 320 is attached to substrate attachment surface 332 formed by bottom surface 336 of device substrate 330. In alternate embodiments, thermally isolating structure 320 may attach at other points such as for example side surface 337 of device substrate 330. In addition, thermally isolating structure 320 has characteristic length or thermal conduction path 318, measured between attachment points 321, that is greater than distance G. By utilizing longer conduction path 318 device substrate 330 may be heated or cooled to a temperature different from the temperature of support structure 340 more efficiently than a straight or short conduction path. Whether device substrate 330 is heated or cooled will depend, for example, on the particular application in which micro-fabricated device 300 will be utilized. An alternate embodiment, of thermally isolating structure 320 is shown, in a cross-sectional view, in Fig. 3c. In this embodiment, thermally isolating structure 320' includes multiple attachment points 321' on both device substrate 330 and support structure 340. Characteristic length 318' is greater than gap width G.

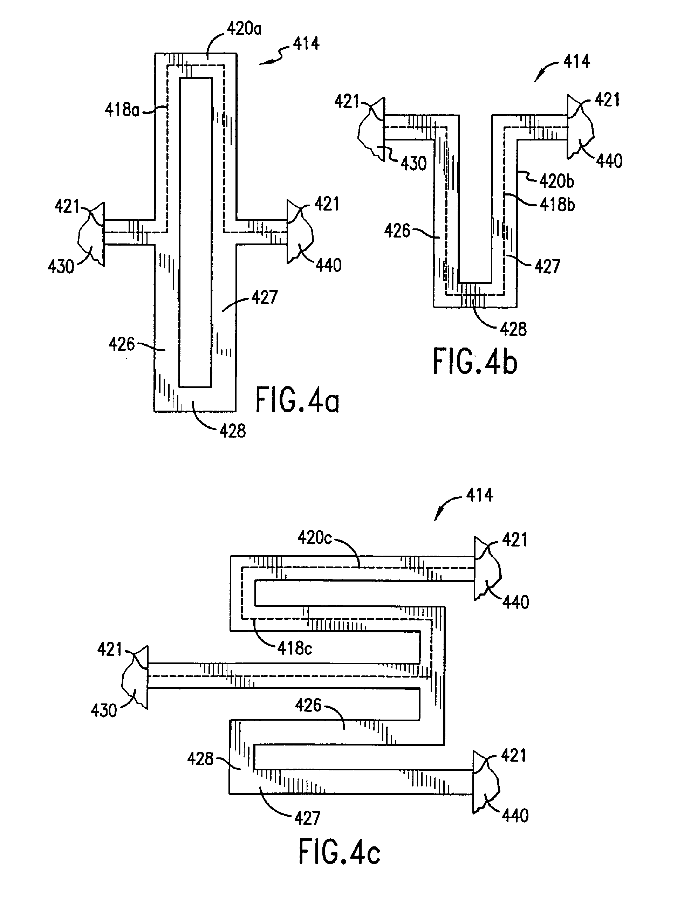

Referring to Figs. 4a-4c alternate embodiments of thermally isolating structures 420a, 420b, and 420c of the present invention are shown in a top view. In this embodiment, thermally isolating structures 420a, 420b, 420c, include first section 426, second section 427 and folding section 428 forming a folded structure having at least one fold. First section 426 and second section 427 are substantially parallel to each other with the three sections 426-428 forming a U shaped structure. Thermally isolating structures 420a, 420b, and 420c each include thermal conduction path 418a, 418b, and 418c respectively, that is longer than the straight line distance measured between attachment points 421. In this embodiment, thermally isolating structures 420a, 420b, and 420c are formed of a single layer having a substantially uniform coefficient of expansion and a substantially uniform composition of matter. In alternate embodiments, thermally isolating structures 420a, 420b, and 420c may be formed utilizing two or more layers depending on the particular application in which the micro-fabricated device will be utilized. In still other embodiments, the cross-sectional area of the thermally isolating structures may also be varied; for example, the cross-sectional area at the attachment point 421 at support structure 440 may be thicker than the crass-sectional area at device substrate 430. In another example the cross-sectional area may vary at various locations of the thermally isolating structure, such as folding section 428 may be thinner than first or second section 426 or 427.

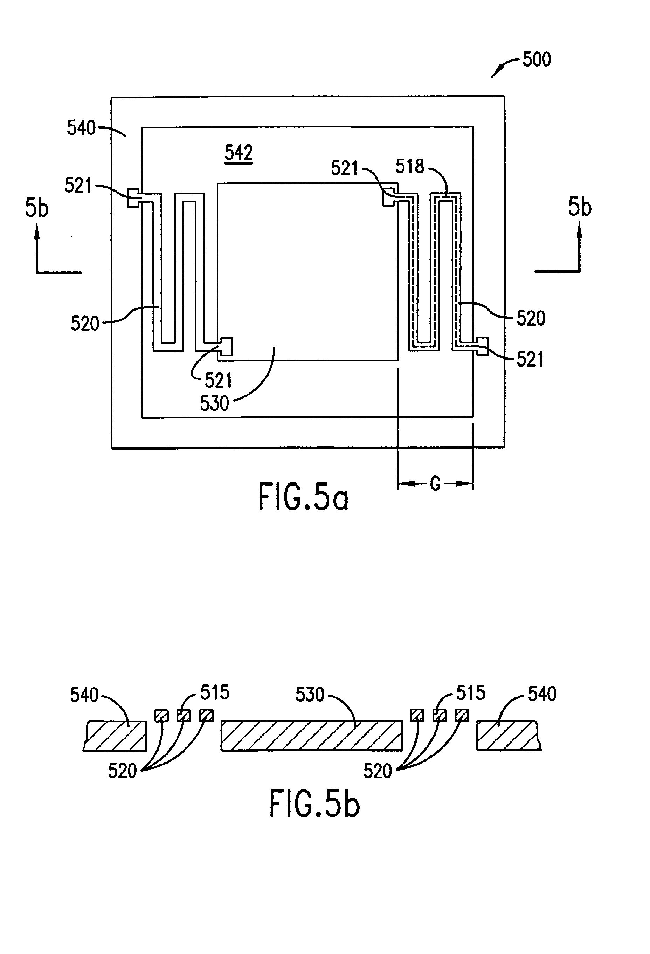

Referring to Fig. 5a, an alternate embodiment of micro-fabricated device 500 of the present invention is shown, in a top view. In this embodiment, device substrate 530 and support structure 540 form a substantially planar structure, however, thermally isolating structure 520 is formed above or out of this substantially planar structure as shown, in cross-sectional view, in Fig. 5b. In addition, in this embodiment, thermally isolating structure 520 is formed from a different material than device substrate 530 and support structure 540. For example, device substrate 530 and support structure 540 may be formed from a silicon wafer and the thermally isolating structures may be formed from a silicon oxide or nitride layer deposited on the silicon wafer. As described in other embodiments, thermally isolating structure 520 reduces the thermal conduction between device substrate 530 and support structure 540 while providing mechanical support.

Device substrate 530 is disposed, within aperture 542 formed in support structure 540, distance G from support structure 540. In addition, themially isolating structure 520 includes thermal conduction path 518, measured between attachment points 521 that is greater than distance G. Cross-sectional area 515 of thermally isolating structure 520, in this embodiment, is uniform providing a uniform coefficient of expansion, as well as, uniform composition of matter. In alternate embodiments, cross-sectional area 515 of thermally isolating structure 520 may be varied to further tune the thermal conduction of isolating structure 520 by varying the thickness of thermally isolating structure 520. Further, in still other embodiments the cross-sectional composition may also be varied, such as, by varying the stoichiometry of, for example, a silicon dioxide or silicon nitride layer varying from oxygen or nitrogen deficient to oxygen or nitrogen rich either along the thermal conduction path 518 or across or through cross-sectional area 515 or some combination thereof. A thermally isolating structure formed from such a layer or layers would have both a non-uniform thermal coefficient of expansion, as well as, a non-uniform composition of matter. In this embodiment, thermally isolating structure 520 may be formed of any suitable material such as a metal, a semiconductor, an inorganic, or a polymeric material or combinations of these materials. For example, an electroplated or sputter deposited metal film, or a spin coated or screen-printed polyimide benzocylcobutene layer are just a couple of materials that may be utilized. The particular material used will depend on the particular application in which micro-fabricated device 500 will be utilized.

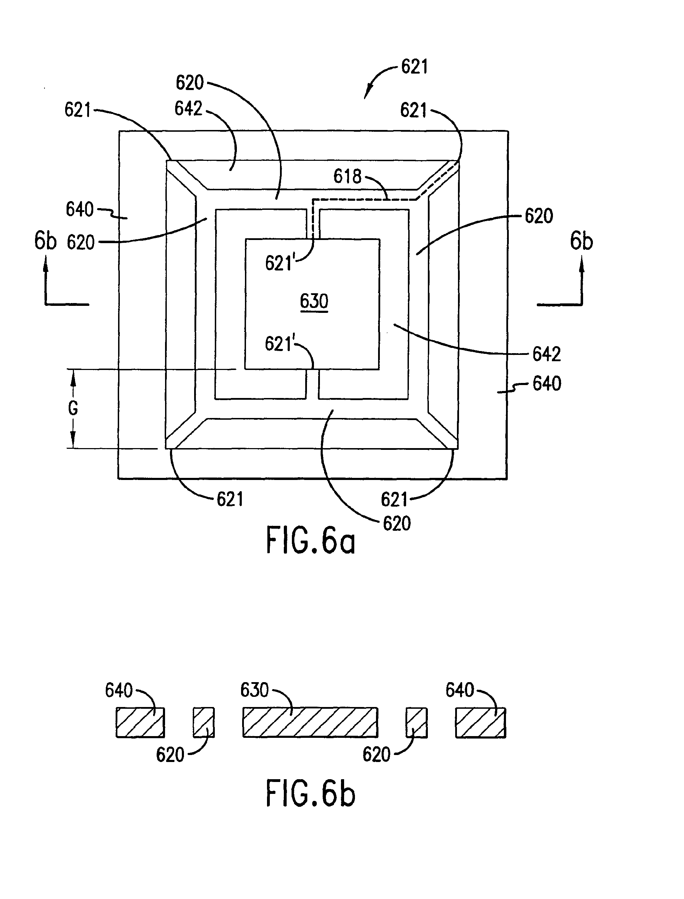

Referring to Fig. 6a, an alternate embodiment of micro-fabricated device 600 of the present invention is shown in a top view. In this embodiment, thermally isolating structure 620 forms an annular structure around device substrate 630. Thermally isolating structure 620 reduces the thermal conduction between device substrate 630 and support structure 640 while providing mechanical support. Device substrate 630 is disposed, within aperture 642 formed in support structure 640, distance G from support structure 640. In addition, thermally isolating structure 620 includes thermal conduction path 618measured between corner attachment point 621 and attachment points 621' on device substrate 630, where thermal conduction path length 618 is greater than distance G. Cross-sectional view 6b illustrates the substantially planar structure of this embodiment. However, thermally isolating structure 620 may also be formed out of the substantially planer structure formed by the device substrate and support structure as illustrated in the embodiment shown in Figs. 5a and 5b.

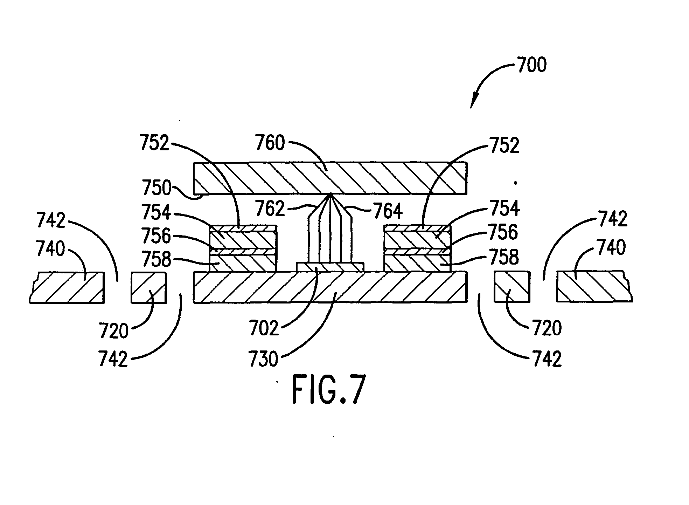

Fig. 7 is an exemplary embodiment of a micro-fabricated device having integrated vacuum device 702 that includes anode surface 750 such as a display screen or a mass storage device that is affected by electrons 762 when they are formed into a focused beam 764. Thermally insulating structure 720 reduces the thermal conduction between device substrate 730 and support structure 740 while providing mechanical support. Device substrate 730 is disposed, within aperture 742 formed in support structure 740. Anode surface 750 is held at a predetermined distance from second electron lens element 752. Micro-fabricated device 700 is enclosed in a vacuum package (not shown).

In this embodiment, integrated vacuum device 702 is shown in a simplified block form and may be any of the electron emitter structures well known in the art such as a Spindt tip or flat emitter structure. Second lens element 752 acts as a ground shield. Vacuum device 702 is disposed over at least a portion of device substrate 730. First insulating or dielectric layer 754 electrically isolates second lens element 752 from first lens element 756. Second insulating layer 758 electrically isolates first lens element 756 from vacuum device 702. In alternate embodiments, more than two lens elements, may be utilized to provide, for example, an increased intensity of electron emission or increased focusing ability for electron beam 764. Both the lens elements and dielectrics are fabricated utilizing conventional semiconductor processing equipment.

As a display screen, an array of pixels (not shown) are formed on anode surface 750, which further are typically arranged in a red, blue, green order, however, the array of pixels may also be a monochromatic color. An array of emitters (not shown) are formed on device substrate 630 where each element of the emitter array has one or more integrated vacuum devices acting as an electron emitter. Application of the appropriate signals to an electron lens structure including first and second electron lens 752 and 756 generates the necessary field gradient to focus electrons 762 emitted from vacuum device 702 and generate focused beam 764 on anode surface 750.

As a mass storage device, anode surface 750 typically includes a phase-change material or storage medium that is affected by the energy of focused beam 764. The phase-change material generally is able to change from a crystalline to an amorphous state (not shown) by using a high power level of focused beam 764 and rapidly decreasing the power level of focused beam 764. The phase-change material is able to change from an amorphous state to a crystalline state (not shown) by using a high power level of focused beam 764 and slowly decreasing the power level so that the media surface has time to anneal to the crystalline state. This change in phase is utilized to form a storage area on anode surface 750 that may be in one of a plurality of states depending on the power level of focused beam 764 used. These different states represent information stored in that storage area.

An exemplary material for the phase change media is germanium telluride (GeTe) and ternary alloys based on GeTe. The mass storage device also contains electronic circuitry (not shown) to move anode surface 750 in a first and preferably second direction relative to focused beam 764, to allow a single integrated vacuum device 702, to read and write multiple locations on anode surface 750. To read the data stored on anode or media surface 750 a lower-energy focused beam 764 strikes media surface 750 that causes electrons to flow through the media substrate 760, and a reader circuit (not shown) detects them. The amount of current detected is dependent on the state, amorphous or crystalline, of the media surface struck by focused beam 764.

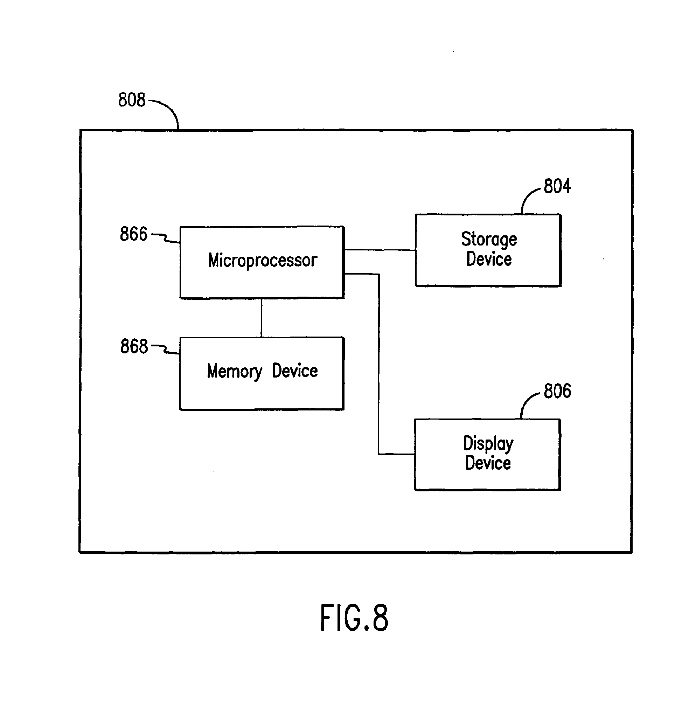

Referring to Fig. 8 an exemplary block diagram of an electronic device 808, such as a computer system, video game, Internet appliance terminal, MP3 player, cellular phone, or personal digital assistant to name just a few is shown. Electronic device 808 includes microprocessor 866, such as an Intel processor sold under the name "Pentium Processor," or compatible processor. Many other processors exist and may also be utilized. Microprocessor 866 is electrically coupled to memory device 868 that includes processor readable memory that is capable of holding computer executable commands or instructions used by the microprocessor 866 to control data, input/output functions, or both. Memory device 868 may also store data that is manipulated by microprocessor 866. Microprocessor 866 is also electrically coupled either to storage device 804, or display device 806 or both. Microprocessor 866, memory device 868, storage device 804, and display device 806 each may contain an embodiment of the present invention as exemplified in earlier described figures and text showing device substrates having thermally isolating structures.

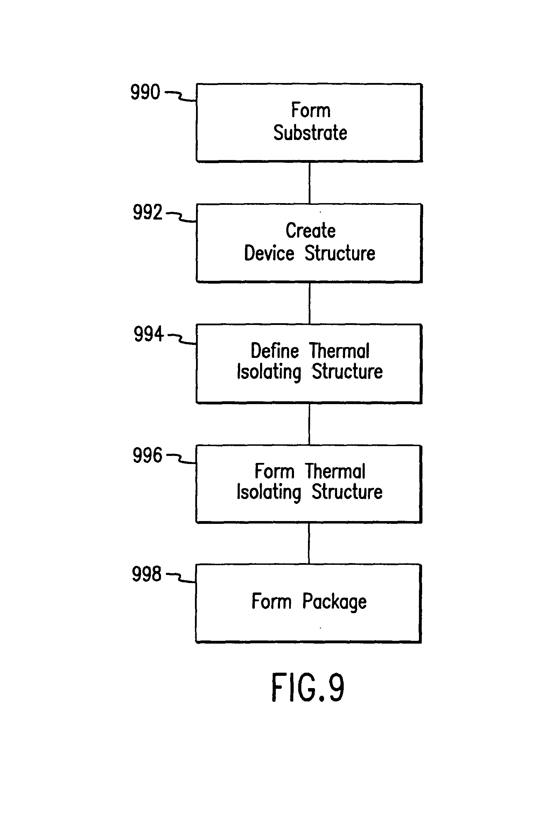

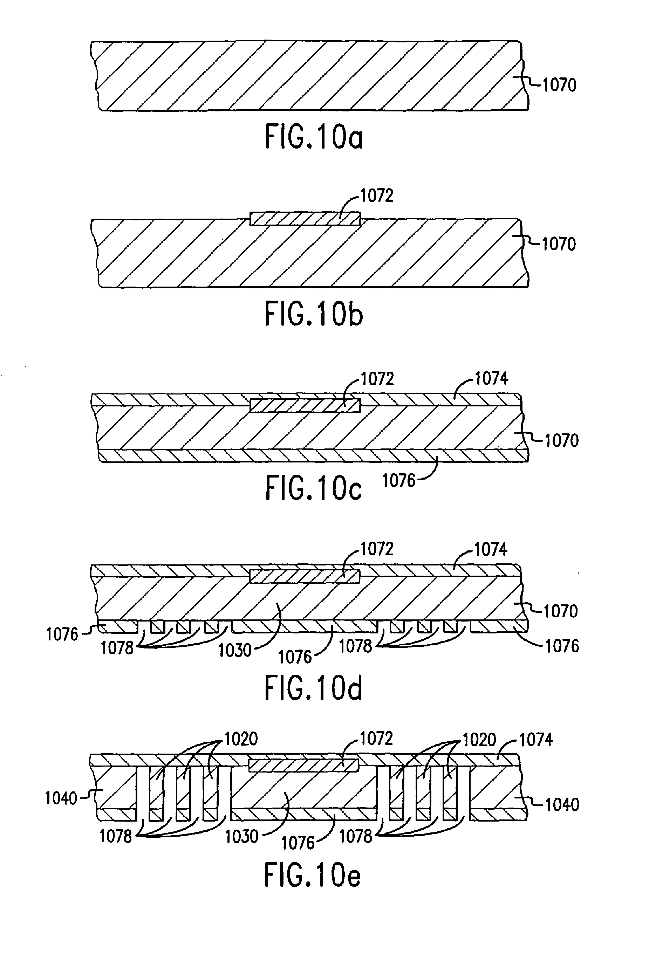

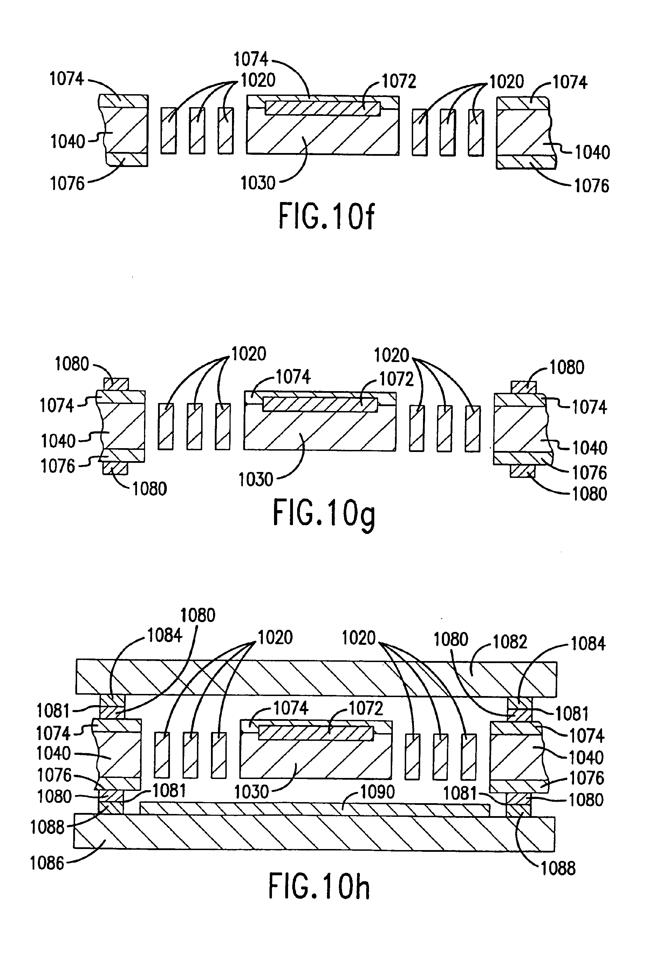

Referring to Fig. 9 a flow diagram of a method of manufacturing a micro-fabricated device, according to an embodiment of the present invention, is shown. Figs. 10a-10h are illustrations of the processes utilized to create a micro-fabricated device, and are shown only to better clarify and understand the invention. Actual dimensions are not to scale and some features are exaggerated to more clearly point out the process.

Substrate forming process 990 is utilized to form the substrate on which the device substrate and the support structure will be created. In this embodiment, wafer 1070 is a single crystal silicon substrate having a thickness of about 200-800 microns as shown in a cross-sectional view in Fig. 10a. However, in alternate embodiments, both other materials and thicknesses may be utilized. For example, gallium arsenide, glass, and polymer substrates are just a few of the alternate materials that may be used in the present invention. Thus, wafer 1070 is not restricted to typical wafer sizes, and may be a polymer sheet or film, or glass sheet, or even a single crystal sheet or substrate handled in a different form and size than that of conventional silicon wafers.

Device structure creation process 992 is utilized to create MEMS structures or active devices or both 1072 on the micro-fabricated device as shown in a cross-sectional view in Fig. 10b. Depending on the particular application in which micro-fabricated device will be utilized any MEMS structure may be created, for example, MEMS structures may include transducers, actuators, sensors, and valves to name a few. In addition, device structure creation process 992 also includes creating various electronic circuits such as for example, transistors, logic circuits, memory cells as well as passive devices such as capacitors, resistors, and inductors. For clarity these devices are represented as a single layer 1072 in Fig. 10b. The particular devices and circuits created will depend on the particular application in which the micro-fabricated device will be utilized. Typically, the electronic circuits are fabricated utilizing conventional IC processing equipment and processes. Bulk or surface micromachining or combinations of both are utilized to form the MEMS structures. For example, an integrated pressure sensor is typically fabricated using IC processing to create the driving and analysis circuits followed by micromachining from the back side of the wafer to create a micromachined diaphragm. Other examples, include infrared sensing arrays formed utilizing IC processing to form thermopiles and other circuitry followed by micromachining to create the sensing array, or fabricating an amplifier operating in the radio frequency range utilizing CMOS technology to fabricate the IC amplifier and micromachining to produce an inductor with the proper resonance frequency. Device structure creation process 992 also includes deposition and pattern generation for electrical traces and interconnect pads providing for the routing of signals and power to various portions of the micro-fabricated device.

Thermally isolating structure definition process 994 is utilized to define the shape or structure of the thermally isolating structures such as the desired thermal conduction path and attachment points. In addition, depending on the particular application in which the micro-fabricated device will be utilized, thermally isolating structure definition process 994 may also be utilized to define the device substrate, and the support structure. Dielectric passivation layer 1074 and etch defining layer 1076 are deposited over silicon substrate 1070 and MEMS or electronic devices or both 1072 as shown, in a cross-seetional view, in Fig 10c. In alternate embodiments dielectric passivation layer 1074 and etch defining layer 1076 may be deposited during device structure creation process depending on the particular devices fabricated as well as the particular application in which the micro-fabricated device will be utilized. Deposition techniques such as plasma enhanced chemical vapor deposition (PECVD), sputter deposition, chemical vapor deposition may be utilized to deposit refractory dielectrics such as silicon oxide, silicon nitride, or silicon carbide to name just a few examples. In alternate embodiments spin coating, curtain coating, or screen printing may also be utilized to form a polymer dielectric passivation layer such as polyimides, or benzocyclobutene are just a couple of examples. After deposition various planarizing processes such as chemical mechanical processing (CMP) may be utilized for those applications desiring a planarized dielectric layer. Etch defining layer 1076 is deposited on the back or opposite side of silicon substrate 1070 as shown in a cross-sectional view in Fig. 10c. In this embodiment, etch defining layer 1076 is a silicon nitride layer, however, in alternate embodiments, other refractory materials such a silicon oxide or silicon carbide or polymeric materials such as a photo resist or polyimide may also be utilized depending on various parameters such as the particular substrate material utilized as well as the particular etchant utilized to form the thermally isolating structure. Etch defining layer 1076 is then patterned utilizing conventional photolithographic technologies and processes to form openings 1078 as shown, in a cross-sectional view, in Fig. 10d. The size and shape of opening 1078 also depends on various parameters such as particular etchant utilized to etch wafer 1070 as well as the wafer or substrate material. In alternate embodiments, opening 1078 may be formed in dielectric passivation layer 1074 or both.

Thermally isolating structure formation process 996 is utilized to form, or generally etch, wafer 1070 and generate thermally isolating structure 1020, device substrate 1030, and support structure 1040. For example, a dry etch may be used when vertical or orthogonal sidewalls are desired. Alternatively an anistropic wet etch such as potassium hyrdoxide (KOH) may be used to etch a (110) oriented silicon wafer to also produce vertical sidewalls. Further, the use of an anisotropic wet etch such as KOH or tetra methyl ammonium hydroxide (TMAH), may be utilized to etch a (100) oriented silicon wafer to produce various structures with sloped side walls generated by the slower etch rate of the (111) crystallographic planes. In still other embodiments, combinations of wet and dry etch may also be utilized when moce complex structures are desired. Further, other processes such as laser ablation, reactive ion etching, ion milling including focused ion beam patterning may also be utilized to form thermally isolating structure 1020, device substrate 1030, and support structure 1040 as shown in Fig. 10e. After thermally isolating structure 1020 is formed portions of dielectric passivation layer 1074 and etch defining layer 1076 may be removed as shown in Fig. 10f. In this embodiment, dielectric passivation layer 1074 and etch defining layer 1076 remain on support structure 1040 to illustrate additional packaging steps, however, in alternate embodiments these layers may be completely removed or left in selective areas, depending on various parameters such as the desired thermal and electrical isolation properties on various portions of the micro-fabricated device.

Package forming process 998 is utilized to create an optional vacuum package that reduces heating or cooling by convection, depending on the particular application in which the micro-fabricated device will be utilized. As shown in a cross-sectional view in Fig. 10g device bond structure 1080 is formed on support structure 1040 over dielectric passivation layer 1074 and etch defining layer 1076. Dielectric passivation layer 1074 and etch defining layer 1076 provide electrical isolation, as well as, reducing the thermal conduction, between the package and support structure 1040. Device bond structure 1080, may be a gold-silicon etutectic for bonding a silicon die to a ceramic package or metal can, or it may be a softer lower melting point solder, to name just a couple of examples of the various materials that may be utilized. Cover or lid bond structure 1084 is formed on cover or lid 1082, and base or package bottom bond structure 1088 is formed on base or package bottom 1086.

The material utilized for device bond structure 1080, cover bond structure 1084 and base bond structure 1088 depends on the particular materials utilized for wafer 1070, cover 1082, and base 1086. Cover 1082 and base 1086 may utilize various, ceramic, glass, or metal materials. The particular material will depend, for example, on the desired pressure to be maintained, on the temperature and humidity and other environmental factors to which the micro-fabricated device will be exposed, and on the amount of stress that may be imparted to the micro-fabricated device as a result of the packaging process; as well as; the particular sealing technology to be utilized. These same parameters are also considered when determining the material to be utilized as bond structures. Seal 1081 can be made by a variety of techniques including thermal compression, brazing, anodic bonding, as well as other techniques.

## Claims

1. A micro-fabricated device (100, 200, 300, 500, 600, 700), comprising
a support structure (140, 140', 240, 340, 440, 540, 640, 740);
a device substrate (130, 130', 230, 330, 430, 530, 630, 730) disposed a distance G from said support structure; and
at least one thermally isolating structure (120, 120', 220, 220', 320, 320', 420a, 420b, 420c, 520, 620, 720) having a characteristic length (118, 218, 318, 318', 418a, 418b, 418c, 518, 618), said at least one thermally isolating structure thermally coupled to said device substrate and said support structure, wherein said characteristic length is greater than said distance G.

2. The micro-fabricated device in accordance with claim 1, wherein said at least one thermally isolating structure, further comprises a folded structure having at least one fold.

3. The micro-fabricated device in accordance with claim 1, wherein said device substrate, further comprises at least one micro fluidic channel disposed on said device substrate.

4. The micro-fabricated device in accordance with claim 1, further comprising at least one active device (234) disposed on said device substrate.

5. The micro-fabricated device in accordance with claim 1, further comprising a package (111) enclosing said device substrate, said package, having a vacuum portion (197) and a fluid flow portion (198), wherein said vacuum portion is sealed at a pressure below atmospheric pressure.

6. The micro-fabricated device in accordance with claim 1, further comprising a vacuum device (702) disposed on said device substrate, said vacuum device having an electron emitter.

7. A storage device, comprising:
at least one micro-fabricated device of claim 6; and
a storage medium (750) in close proximity to said at least one electronic device, said storage medium having a storage area in one of a plurality of states to represent information stored in that storage area.

8. A computer system, comprising:
a microprocessor (866);
an electronic device including at least one micro-fabricated device of claim 1 coupled to said microprocessor; and
memory coupled (868) to said microprocessor, said microprocessor operable of executing instructions from said memory to transfer data between said memory and the electronic device.

9. The computer system in accordance with claim 8, wherein said microprocessor further comprises a micro-fabricated device having:
a support structure (140, 140', 240, 340, 440, 540, 640, 740);
a device substrate (130, 130', 230, 330, 430, 530, 630, 730) disposed a distance G from said support structure; and
at least one thermally isolating structure (120, 120', 220, 220', 320, 320', 420a, 420b, 420c, 520, 620, 720) having a characteristic length (118, 218, 318, 318', 418a, 418b, 418c, 518, 618), said at least one thermally isolating structure thermally coupled to said device substrate and said support structure, wherein said characteristic length is greater than said distance G.

10. A micro-fabricated device, comprising:
a device substrate (130, 130', 230, 330, 430, 530, 630, 730);
means to support said device substrate; and
means to reduce thermal conduction between said device substrate and
said support structure.

11. A method of manufacturing a micro-fabricated device, comprising:
forming a support structure;
defining a device substrate (784) disposed a distance G from said support structure; and
forming at least one thermally isolating structure (788), having a characteristic length greater than said distance G, and thermally coupled to said device substrate and said support structure.

12. The method in accordance with claim 11, wherein forming at least one thermally isolating structure, further comprises forming a folded structure having at least one fold.

13. A micro-fabricated device manufactured in accordance with claim

14. The method in accordance with claim 11, wherein forming said at least one thermally isolating structure, further comprises forming a cross-sectional area of said at least one thermally isolating structure that varies.

15. The method in accordance with claim 11, wherein defining said device substrate, further comprises forming at least one micro fluidic channel on said device substrate.

16. The method in accordance with claim 11, wherein forming said support structure further comprises forming an aperture in said support structure with said device substrate disposed within said aperture forming a substantially planar structure.

17. The method in accordance with claim 11, further comprising forming a package (790) around said device substrate and said at least one thermally isolating structure, said package having a vacuum portion and a fluid flow portion, wherein said vacuum portion is sealed at a pressure below atmospheric pressure.

18. A micro-fabricated device manufactured in accordance with claim

19. The method in accordance with claim 11, wherein forming said package further comprises:
interposing a reflecting surface interposed between a cover and said device substrate; and
forming an outer vacuum package enclosing said reflecting surface.

20. A micro-fabricated device manufactured in accordance with claim 11.
